**Europäisches Patentamt**

**European Patent Office**

**Office européen des brevets**

(19)

(11) **EP 1 184 722 A2**

(12) **EUROPÄISCHE PATENTANMELDUNG**

(43) Veröffentlichungstag:
**06.03.2002 Patentblatt 2002/10**

(51) Int Cl.⁷: **G03F 1/00**, G03F 1/14

(21) Anmeldenummer: **01120628.1**

(22) Anmeldetag: **29.08.2001**

(84) Benannte Vertragsstaaten:
**AT BE CH CY DE DK ES FI FR GB GR IE IT LI LU
MC NL PT SE TR**
Benannte Erstreckungsstaaten:
**AL LT LV MK RO SI**

(30) Priorität: **31.08.2000 DE 10042929**

(71) Anmelder: **Infineon Technologies AG
81669 München (DE)**

(72) Erfinder:
• **Ahrens, Marco
85664 Hohenlinden (DE)**
• **Maurer, Wilhelm, Dr.
85662 Hohenbrunn-Riemerling (DE)**
• **Knobloch, Jürgen, Dr.
81371 München (DE)**
• **Zimmermann, Rainer, Dr.
81671 München (DE)**

(74) Vertreter: **Reinhard - Skuhra - Weise & Partner
Postfach 44 01 51
80750 München (DE)**

(54) **OPC-Verfahren zum Erzeugen von korrigierten Mustern für eine Phasensprungmaske und deren Trimmmaske sowie zugehörige Vorrichtung und integrierte Schaltungsstruktur**

(57) Erläutert wird unter anderem ein Verfahren, bei dem zunächst in einem ersten Korrekturschritt (60) das Muster (56) für die Phasensprungmaske korrigiert wird. Anschließend wird in einem zweiten Korrekturschritt (66) das Muster für die Trimmmaske bei Einsatz des korrigierten Musters (64) für die Phasensprungmaske korrigiert. Durch die beiden nacheinander ausgeführten Korrekturschritte lassen sich Maskendaten für die Herstellung höchstintegrierter Schaltkreise auf einfache Art korrigieren.

FIG 2

## Beschreibung

Die Erfindung betrifft ein Verfahren zum Erzeugen von korrigierten Mustern für eine Phasensprungsmaske und deren zugehöriger Trimmmaske. Bei dem Verfahren wird ein Ursprungs-Layout zur Herstellung einer Schaltungsstruktur mit Hilfe eines Photo-Lithografieverfahrens vorgegeben. Aus dem Ursprungs-Layout wird ein Muster für eine Phasensprungmaske erzeugt, mit deren Hilfe ein Teil der Schaltungsstruktur hergestellt werden soll. Außerdem wird aus dem Ursprungs-Layout ein Muster für eine Trimmmaske erzeugt, mit deren Hilfe sich an die Schaltungsstruktur des ersten Teils anschließende Strukturen der Schaltungsstruktur herstellbar sind und mit deren Hilfe Stellen belichtet werden, an denen direkte Phasenübergänge der Phasenmaske liegen. Das Muster für die Phasensprungmaske und das Muster für die Trimmmaske werden unter Berücksichtigung von Nachbarschaften der Strukturen der Muster mit Einfluss auf die Abbildung bei der Photolithografie so korrigiert, dass eine mit den korrigierten Mustern herstellbare Schaltungsstruktur hinsichtlich der Geometrie dem Ursprungs-Layout ähnlicher als eine mit den unkorrigierten Mustern herstellbare Schaltungsstruktur ist.

Ein solches Verfahren wird allgemein als OPC-Verfahren (optical proximity correction) bezeichnet, weil nachbarschaftsinduzierte Beugungseffekte korrigiert werden. Bei der Korrektur werden Nachbarschaften berücksichtigt die einen Einfluss auf die Abbildung bei der Photolithografie haben.

Die Phasensprungmaske ist entweder eine Dunkelfeldmaske oder eine Hellfeldmaske. Beispielsweise enthält eine Phasensprungmaske vom Dunkelfeldtyp mindestens zwei Arten strahlungsdurchlässiger Gebiete mit voneinander unterschiedlichem Einfluss auf die Phase von durch die Durchtrittsgebiete übertragenen elektromagnetischen Wellen. Üblicherweise wird zwischen benachbarten Durchtrittsgebieten ein Phasensprung von 180° erzeugt.

Ein Verfahren mit den oben genannten Verfahrensschritten ist in dem Artikel "Integration of Optical Proximity Correction Strategies in Strong Phase Shifters Design for Poly-Gate Layers" von Christopher Spence, Marina Plat, Emile Sahouria, u.a., erläutert. Dieser Artikel ist Teil des 19th Annual BACUS Symposium on Photomask Technology, Monterey, California, September 1999 und in SPIE, Vol. 3873, Seiten 277 bis 287, veröffentlicht. Bei der Korrektur werden die Muster für die Phasensprungmaske und die Trimmmaske simultan korrigiert. In der Veröffentlichung werden Schaltungsstrukturen mit einer kritischen Dimension CD von 100 nm mit Hilfe von 248 nm Lithografie-Apparaten hergestellt. Zusätzlich wird der Herstellungsprozess simuliert. In der Veröffentlichung dargestellte Strukturen haben jedoch vergleichsweise große Abstände voneinander. Das Verhältnis von minimalem Abstand der Strukturen zu minimaler Strukturbreite ist wesentlich größer als zwei.

Es ist Aufgabe der Erfindung, ein verbessertes OPC-Verfahren zum Korrigieren von Mustern für eine Phasensprungmaske und deren Trimmmaske anzugeben. Außerdem sollen eine zugehörige Vorrichtung, ein zugehöriges Programm, ein Datenträger mit diesem Programm sowie eine integrierte Schaltungsstruktur angegeben werden.

Die das Verfahren betreffende Aufgabe wird durch die im Patentanspruch 1 angegebenen Verfahrensschritte gelöst. Weiterbildungen sind in den Unteransprüchen angegeben.

Die Erfindung geht von der Überlegung aus, dass Phasensprungmasken üblicherweise zum Herstellen von Schaltungsstrukturen eingesetzt werden, deren kritische Dimension so klein ist, dass bei der Abbildung der Strukturen mit Hilfe der Masken Nachbarschaften der Strukturen die Abbildung beeinflussen. Eine gleichzeitige Korrektur des Musters der Phasensprungmaske und des Musters der Trimmmaske ist zwar möglich, jedoch mit einem vergleichsweise großen Aufwand verbunden, weil sich der Einfluss der Nachbarschaften auf die Abbildung bei der Photolithografie nur schwer abschätzen lässt.

Beim erfindungsgemäßen Verfahren wird zusätzlich zu den eingangs genannten Verfahrensschritten zunächst in einem ersten Korrekturschritt das Muster für die Phasensprungmaske nach Korrekturvorschriften für das Muster der Phasensprungmaske korrigiert. Anschließend wird dann in einem zweiten Korrekturschritt das Muster für die Trimmmaske bei Einsatz des korrigierten Musters für die Phasensprungmaske nach Korrekturvorschriften für das Muster der Trimmmaske korrigiert. Durch die Trennung der Korrektur des Musters für die Phasensprungmaske von der Korrektur des Musters für die Trimmmaske wird erreicht, dass während des Korrekturverfahrens nicht so viele verschiedene Einflüsse gleichzeitig berücksichtigt werden müssen. Somit ist der Einfluss der Nachbarschaften auf die Abbildung bei der Photolithografie besser beherrschbar. Insgesamt ist der Aufwand für die Korrektur beim erfindungsgemäßen Verfahren erheblich geringer als bei gleichzeitiger Korrektur beider Muster.

Bei einer Alternative des erfindungsgemäßen Verfahrens wird zunächst in einem ersten Korrekturschritt das Muster für die Trimmmaske nach Korrekturvorschriften für das Muster der Trimmmaske korrigiert. Anschließend wird dann in einem zweiten Korrekturschritt das Muster für die Phasensprungmaske bei Einsatz des korrigierten Musters für die Trimmmaske nach Korrekturvorschriften für das Muster der Phasensprungmaske korrigiert. Somit ist die Reihenfolge der Korrekturschritte wählbar. Die Reihenfolge wird so festgelegt, dass möglichst einfache Korrekturvorschriften aufgestellt werden können.

Bei einer Weiterbildung wird im ersten Korrekturschritt das Muster für die Phasensprungmaske bei Einsatz des unkorrigierten Musters für die Trimmmaske korrigiert. Alternativ wird im ersten Korrekturschritt das Muster für die Trimmmaske bei Einsatz des unkorrigierten Musters für die Phasensprungmaske korrigiert. Durch diese Maßnahmen lassen sich genauere Korrekturvorschriften ermitteln.

Im ersten Korrekturschritt werden vorzugsweise im wesentlichen alle bzw. alle Korrekturen durchgeführt, die sich nach den vorgegebenen Korrekturvorschriften für die erste korrigierte Maske an deren Muster ausführen lassen. Im zweiten Korrekturschritt werden dann im wesentlichen alle bzw. alle Korrekturen ausgeführt, die sich zum Zeitpunkt der Ausführung des Verfahrens nach den für die zweite zu korrigierende Maske vorgegebenen Korrekturvorschriften an dem Muster der als zweite Maske korrigierten Maske ausführen lassen. Im wesentlichen alle bedeutet, dass beispielsweise einzelne Korrekturen später noch manuell im Sinne einer Nachbesserung ausgeführt werden können. Es werden also Korrekturen an allen Stellen des Musters ausgeführt, an denen Korrekturen gemäß der Korrekturvorschriften ausführbar sind. Die Korrekturschritte sind so klar voneinander getrennt.

Beispielsweise werden aufgrund der Korrekturvorschriften:

- Linienverkürzungen bei der Herstellung der Schaltungsstruktur im Vergleich zum Muster bzw. Ursprungs-Layout durch Verlängerung der betreffenden Struktur in einem der beiden Muster beseitigt,
- Abrundungen von Ecken in der hergestellten Schaltungsstruktur bzw. bei der Simulation der Herstellung auftretende Abrundungen von Ecken durch "Anstückeln" von Korrekturflächen in einem der beiden Muster vermieden, und
- Einengungen bei der hergestellten bzw. simulierten Schaltungsstruktur vermieden, indem die diese Schaltungsstrukturen hervorrufende Strukturen in einem der beiden Muster in den Bereichen der Einengung verbreitert werden.

Bei einer nächsten Weiterbildung des Verfahrens ist die Korrektur nach Ausführung des zweiten Korrekturschritts im wesentlichen beendet, d.h. beispielsweise abgesehen von geringen manuellen Nachbesserungen.

Die mit Hilfe des erfindungsgemäßen Verfahrens bzw. mit Hilfe von dessen Weiterbildungen erzeugten Muster werden als Grundlage bei der Herstellung oder der Simulation der Herstellung einer Phasensprungmaske und einer Trimmmaske eingesetzt. Beispielsweise werden Maskendaten erzeugt, die direkt in einen Maskenschreiber eingegeben werden können. Wird dagegen der Herstellungsprozess simuliert, so lassen sich Masken für Schaltungsstrukturen entwickeln, die erst in ein oder zwei Jahren hergestellt werden, weil die zur Herstellung benötigten Vorrichtungen noch entwickelt werden. Aufgrund der Simulation der Herstellung der Schaltung lassen sich sehr früh Fehler im Muster erkennen und korrigieren. In diesem Fall wird das erfindungsgemäße Verfahren bzw. seine Weiterbildungen mehrmals ausgeführt, wobei anstelle des Ursprungs-Layouts ein neues Ursprungslayout verwendet wird. Alternativ oder zusätzlich lassen sich auch Veränderungen am ursprünglichen Muster für die Phasensprungmaske und/oder am Muster für die Trimmmaske vornehmen.

Bei einer nächsten Weiterbildung sind die Muster durch Masken-Daten festgelegt. Das Verfahren wird mit Hilfe mindestens einer Datenverarbeitungsanlage ausgeführt. Bei einer Ausgestaltung erfolgt die Korrektur automatisch. Die Weiterbildung und die Ausgestaltung werden insbesondere zur Vorbereitung der Herstellung von höchstintegrierten Schaltungsstrukturen eingesetzt, z.B. von Mikroprozessoren oder Speicherbausteinen. Die Korrektur von mehreren Millionen Teilstrukturen der Muster lässt sich so auf einfache Weise und mit vertretbarem Aufwand durchführen.

Die Erfindung betrifft außerdem eine Vorrichtung zum Korrigieren von Mustern für eine Phasensprungmaske und deren Trimmmaske, insbesondere eine Datenverarbeitungsanlage. Die Vorrichtung enthält eine Speichereinheit zum Speichern der Daten des Ursprungs-Layouts, der Daten des Musters für die Phasensprungmaske und der Daten des Musters für die Trimmmaske. Eine Korrektureinheit führt die Korrektur des Musters der Phasensprungmaske und die Korrektur des Musters der Trimmmaske durch. Dabei werden nacheinander die beiden oben erwähnten Korrekturschritte ausgeführt. Somit gelten die oben im Zusammenhang mit dem erfindungsgemäßen Verfahren genannten technischen Wirkungen auch für die erfindungsgemäße Vorrichtung.

Bei Weiterbildungen ist die Vorrichtung so aufgebaut, dass sie im Betrieb ein Verfahren nach einer Weiterbildung des erfindungsgemäßen Verfahrens ausführt. Beispielsweise wird die Korrektur automatisch ausgeführt.

Die Erfindung betrifft außerdem ein Programm zum Korrigiere von Mustern für eine Phasensprungmaske und deren Trimmmaske. Beim Ausführen der Befehle des Programms durch einen Prozessor werden die Korrekturschritte des erfindungsgemäßen Verfahrens ausgeführt. Somit gelten die oben genannten technischen Wirkungen auch für das Programm.

Bei einer Weiterbildung ist ein Teil der Befehle des Programms in einer Datei enthalten, die Befehle einer Kommandosprache zur Steuerung des Programmablaufs enthält. Durch den Einsatz sogenannter Script-Dateien lassen sich Programme zur Ausführung des erfindungsgemäßen Verfahrens einsetzen, die zwar zur Durchführung des Verfahrens grundsätzlich geeignet sind, bei denen die Inhalte der Script-Datei jedoch noch nicht in den Quell-Code übernommen worden sind. Dies kann zu einem späteren Zeitpunkt erfolgen. Ein Programm, das zur Ausführung des Verfahrens mit Hilfe einer Script-Datei geeignet ist, ist beispielsweise das Programm "Optissimo" der Firma aiss GmbH, München, Deutschland, in der Version des Jahres 2000.

Bei einer nächsten Weiterbildung des erfindungsgemäßen Programms ist das Programm so aufgebaut, dass bei der Ausführung seiner Befehle ein Verfahren nach einer der oben genannten Weiterbildungen der Erfindung ausgeführt wird. Die oben genannten technischen Wirkungen gelten demzufolge auch für die Weiterbildungen des Programms.

Mit der Erfindung bzw. ihren Weiterbildungen lassen sich integrierte Schaltungsstrukturen herstellen, für deren minimale kritische Dimension gilt:

$$MinCD = k1 \cdot \lambda/NA,$$

wobei $\lambda$ die Wellenlänge einer bei der Herstellung eingesetzten Strahlungsquelle zum Belichten eines Strahlungsresists, NA die numerische Apertur einer bei der Herstellung eingesetzten Projektionsoptik und k1 ein empirischer Faktor sind. Derzeit werden üblicherweise Strahlungsquellen mit einer Wellenlänge von 248 nm eingesetzt. Absehbar ist jedoch bereits der Einsatz von Strahlungsquellen mit 193 nm bzw. 157 nm. Die numerischer Apertur liegt beispielsweise bei 0,6 bis 0,85. Außerdem ist das Verhältnis des minimalen Abstandes der Strukturen zur minimalen Strukturbreite kleiner als 1,5, d.h. die Strukturen liegen vergleichsweise dicht. Der empirische Faktor k1 ist kleiner als 0,35 oder stimmt mit diesem Wert überein.

Durch die Erfindung betroffen sind auch Schaltungsstrukturen, die unter Verwendung von Masken hergestellt werden, deren Muster gemäß dem erfindungsgemäßen Verfahren vorgegeben werden. Weiterhin sind eine Phasensprungmaske und eine Trimmmaske geschützt, die mit Hilfe des erfindungsgemäßen Verfahrens oder einer seiner Weiterbildungen hergestellt worden sind.

Im folgenden werden Ausführungsbeispiele der Erfindung an Hand der beiliegenden Zeichnungen erläutert. Darin zeigen:

Figur 1 ein Ursprungs-Layout mit zwei aktiven Bereichen,

Figur 2 Verfahrensschritte bei der Herstellung eines integrierten Schaltkreises,

Figur 3 ein unkorrigiertes Muster für eine Phasensprungmaske,

Figur 4 ein korrigiertes Muster für eine korrigierte Phasensprungmaske,

Figur 5 ein unkorrigiertes Muster für eine Trimmmaske,

Figur 6 ein korrigiertes Muster für eine korrigierte Trimmmaske,

Figur 7 das Ergebnis der Simulation des Herstellungsprozesses des integrierten Schaltkreises unter Verwendung der korrigierten Muster,

Figur 8 eine mit Hilfe eines Raster-Elektronen-Mikroskops erstellte Aufnahme eines unter Verwendung der unkorrigierten Muster hergestellten integrierten Schaltkreises, und

Figur 9 das Ergebnis der Simulation des Herstellungsprozesses des integrierten Schaltkreises unter Verwendung der unkorrigierten Muster.

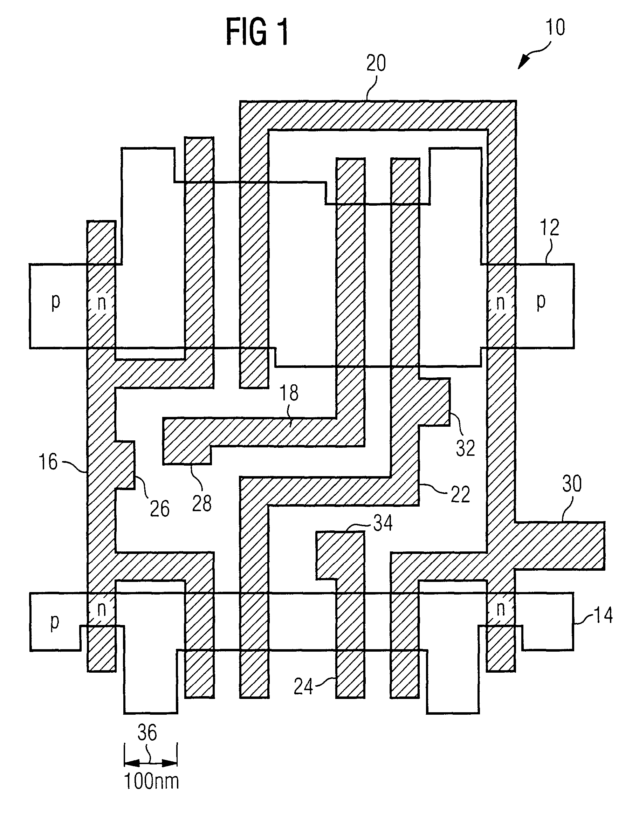

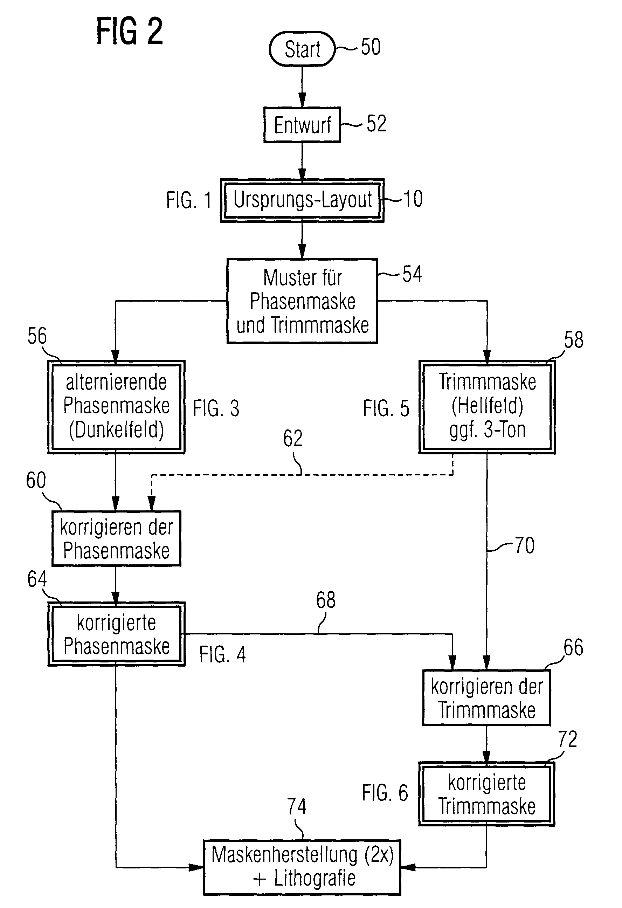

Figur 1 zeigt ein Ursprungs-Layout 10 mit zwei aktiven Bereichen 12 und 14. Eine unter der mit Hilfe des Ursprungs-Layouts 10 herzustellenden Schicht liegende Schicht wird unterhalb des den aktiven Bereichen 12 und 14 entsprechenden Bereiches beispielsweise p-dotiert. Das Ursprungs-Layout 10 enthält außerdem fünf Leitungsstrukturen 16 bis 24. Den Leitungsstrukturen 16 bis 24 entsprechen Leitungsstrukturen im herzustellenden integrierten Schaltkreis. Entsprechend bedeutet hierbei, dass die Schaltungsstrukturen bezüglich eines vorgegebenen Bezugspunktes in der Schaltungsstruktur an derselben Stelle liegen wie die entsprechende Leitungsstruktur im Ursprungs-Layout 10. Innerhalb der den aktiven Bereichen 12 und 14 entsprechenden Bereichen werden die den Leitungsstrukturen 16 bis 24 entsprechenden Schaltungsstrukturen n-dotiert, und bilden so die Steueranschlüsse (Gate) von Transistoren. Außerhalb der aktiven Bereiche 12 und 14 sind die den Leitungsstrukturen 16 bis 24 entsprechenden Leitungsstrukturen gute elektrische Leiter und haben die Funktion von Verbindungsleitungen. Jede Leiterstruktur 16 bis 24 hat außerdem eine Anschlussfläche 26, 28, 30, 32 bzw. 34. Den Anschlussflächen 26 bis 34 entsprechende Anschlussflächen in der Schaltungsstruktur dienen zum Zuführen bzw. Abnehmen von elektrischen Signalen.

Eine Maßstabsstrecke 36 hat die Länge von 1 cm und entspricht 100 nm der späteren Schaltungsstruktur. Zur Herstellung der Schaltungsstruktur wird bei der Belichtung der Masken Licht mit einer Wellenlänge von 248 nm eingesetzt. Die numerische Apertur der Belichtungseinheit beträgt 0,63.

Figur 2 zeigt Verfahrensschritte bei der Herstellung eines integrierten Schaltkreises. Das Verfahren beginnt in einem Verfahrensschritt 50 mit der Vorgabe von Entwurfsanforderungen.

In einem folgenden Verfahrensschritt 52 wird durch eine Design-Abteilung gemäß der im Verfahrensschritt 50 vorgegebenen Vorgaben ein Entwurf erarbeitet. Ergebnis des Verfahrensschritts 52 ist das Ursprungs-Layout 10, siehe Figur 1. In Figur 2 sind Layouts und Muster im Gegensatz zu Verfahrensschritten durch einen doppelten Rahmen dargestellt.

In einem dem Verfahrensschritt 52 folgenden Verfahrensschritt 54 werden ausgehend vom Ursprungs-Layout 10 Masken-Daten für eine Phasensprungmaske und Masken-Daten für eine Trimmmaske erzeugt. Unter anderem werden im Verfahrensschritt 54 die Entwurfsregeln geprüft (Design-Rule-Check). Außerdem werden Bereiche festgelegt, deren Schaltungsstrukturen mit der Phasensprungmaske erzeugt werden sollen. In den anderen Bereichen werden die Schaltungsstrukturen mit Hilfe der Trimmmaske erzeugt. Mit Hilfe der sogenannten Färbungsmethode wird geprüft, ob die Durchtrittsgebiete der Phasensprungmaske so angeordnet sind, dass zwischen jeweils benachbarten Durchtrittsgebieten ein Phasensprung von 180° erzeugt werden kann.

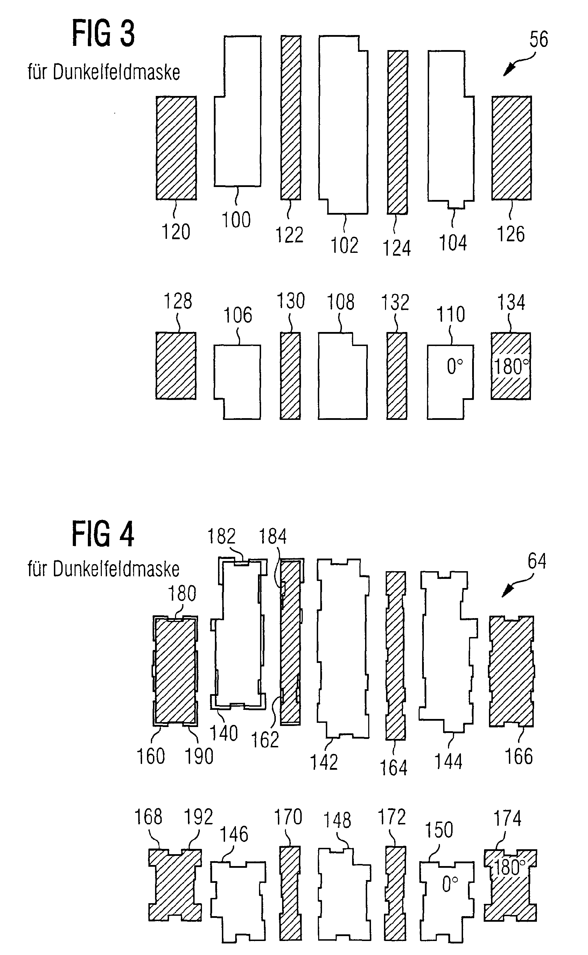

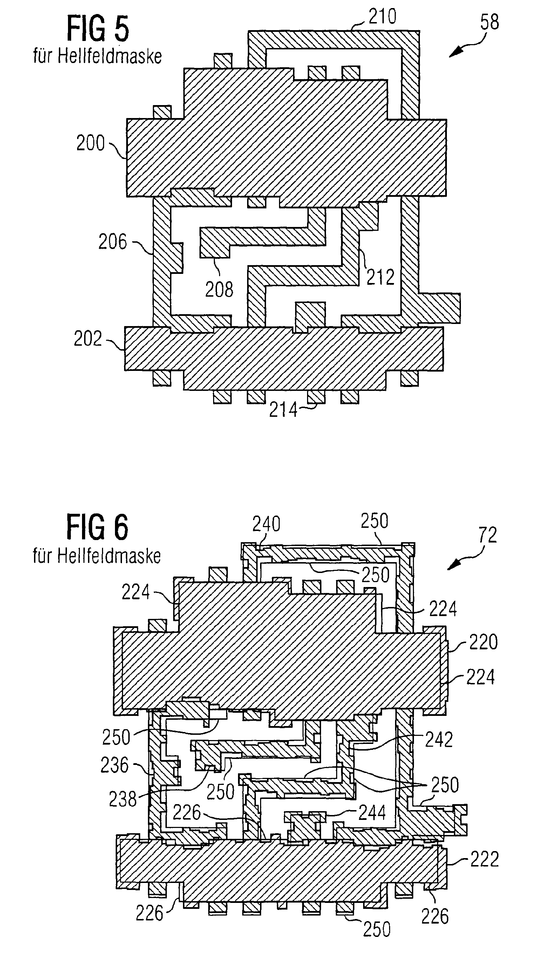

Am Ende des Verfahrensschritts 54 liegen die Muster 56 bzw. 58 einer alternierenden Phasensprungmaske bzw. einer Trimmmaske vor. Die geometrische Struktur, d.h. das Muster 56 der Phasensprungmaske wird unten an Hand der Figur 3 näher erläutert. An Hand der Figur 5 wird unten das Muster 58 der Trimmmaske erläutert.

Nach dem Verfahrensschritt 54 wird in einem Verfahrensschritt 60 das Muster 56 der Phasensprungmaske korrigiert. Ziel der Korrektur ist es, Abweichungen zwischen dem Ursprungs-Layout 10 und der geometrischen Struktur der bei der Herstellung des integrierten Schaltkreises entstehenden Schaltungsstruktur entgegenzuwirken. So sollen insbesondere Linienverkürzungen und zu starke Eckenabrundungen verhindert werden. Im Verfahrensschritt 60 wird das unkorrigierte Muster 58 der Trimmmaske nicht bei der Nachbildung des Belichtungsprozesses eingesetzt. An Hand der Nachbildung des Belichtungsprozesses und der anschließenden Simulation des Herstellungsprozesses der integrierten Schaltung lassen sich u.a. Linienverkürzungen, Eckenabrundungen, Strukturbreitenveränderungen, Strukturbreitenvariationen sowie ein Versatz von Strukturen feststellen. Mit Hilfe vorgegebener Korrekturvorschriften für die Phasensprungmaske werden die festgestellten Abweichungen korrigiert. Ergebnis der Korrektur ist ein korrigiertes Muster 64 der Phasensprungmaske. Das Muster wird unten an Hand der Figur 4 näher erläutert.

In einem dem Verfahrensschritt 60 folgenden Verfahrensschritt 66 wird das Muster 58 der Trimmmaske korrigiert, um Abbildungsfehler bei der Belichtung mit der Trimmmaske auszugleichen. Für die Korrektur des Musters 58 der Trimmmaske wird das Muster 58 der Trimmmaske und das korrigierte Muster 64 der Phasensprungmaske eingesetzt, vgl. Pfeile 68 und 70. Bei der Korrektur im Verfahrensschritt 66 wird das Muster 58 der Trimmmaske so verändert, dass insbesondere Linienverkürzungen, Eckenabrundungen, Strukturbreitenveränderungen, Strukturbreitenvariationen und ein Versatz von Strukturen bei der Herstellung des integrierten Schaltkreises ausgeglichen werden.

Die bereits im Verfahrensschritt 60 korrigierte Phasensprungmaske 64 bleibt im Verfahrensschritt 66 unverändert. Zur Nachbildung des Belichtungsprozesses und zur Simulation des Herstellungsverfahrens wird also die korrigierte Phasensprungmaske 64 eingesetzt. Ergebnis des Verfahrensschrittes 66 ist eine korrigierte Trimmmaske 72, deren Struktur unten an Hand der Figur 6 näher erläutert wird.

Dem Verfahrensschritt 66 folgt ein Verfahrensschritt 74, in welchem die Phasensprungmaske aufgrund der Muster-Daten des Musters 64 und die Trimmmaske aufgrund der Muster-Daten des Musters 72 mit Hilfe eines Maskenschreibers hergestellt werden. Anschließend wird der integrierte Schaltkreis hergestellt. Dabei wird zunächst ein mit einem beispielsweise positiv arbeitenden Fotoresist beschichtetes Substrat in einer Photoprojektionsvorrichtung zweimal belichtet; einmal mit der Phasensprungmaske und einmal mit der Trimmmaske. Anschließend wird die Fotoresistschicht entwickelt, wobei der Fotolack an den belichteten Stellen entfernt wird. Danach wird in einem naßchemischen Ätzprozess das Substrat an den freigelegten Bereichen abgetragen.

Figur 3 zeigt das unkorrigierte Muster 56 für die Phasensprungmaske. Die Phasensprungmaske ist in diesem Fall eine sogenannte Dunkelfeldmaske. Dies erfordert, dass die im Muster 56 außerhalb von Durchtrittsgebieten 100 bis 110 und von Durchtrittsgebieten 120 bis 136 liegenden Bereiche strahlungsundurchlässig sind. Die Durchtrittsgebiete 100 bis 110 sowie die Durchtrittsgebiete 120 bis 134 stellen dagegen lichtdurchlässige Gebiete der Phasensprungmaske dar. Jedoch unterscheidet sich die Dicke der Phasensprungmaske innerhalb der Durchtrittsgebiete 100 bis 110 im Vergleich zu den Durchtrittsgebieten 120 bis 134. Der Dickenunterschied ist so bemessen, dass die Phase des auf die Phasensprungmaske auftreffenden Lichtes in den Durchtrittsgebieten 100 bis 110 nicht geändert wird, d.h. es tritt keine Phasenverschiebung in den Durchtrittsgebieten 100 bis 110 auf, siehe 0° in Figur 3. Beim Durchtritt des Lichtes durch die Durchtrittsgebiete 120 bis 134 wird dagegen die Phase im Vergleich zu dem durch die Durchtrittsgebiete 100 bis 110 hindurchtretenden Licht um 180° verschoben, siehe 180° in Figur 3. Die Durchtrittsgebiete 100 bis 110 sowie 120 bis 134 wechseln einander ab, so dass eine destruktive Interferenz zwischen benachbarten Durchtrittsgebieten 110 bis 134 auftritt. Diese destruktive Interferenz ermöglicht das Herstellen von in ihren Abmessungen kritischen Strukturen, weil bei der Belichtung zwischen benachbarten Durchtrittsgebieten dunkle Bereiche entstehen, in denen später die Leitungsstrukturen liegen, z.B. zwischen den Durchtrittsgebieten 100 und 122 der rechte obere Zweig der der Leitungsstruktur 16 entsprechenden Leitungsstruktur. In Figur 3 sind die Durchtrittsgebiete 120 bis 134 zur Unterscheidung von den Durchtrittsgebieten 100 bis 110 mit einem Punktraster bedeckt.

Die Durchtrittsgebiete 100 bis 110 und 120 bis 134 liegen im Bereich der aktiven Bereiche 12 und 14, siehe Figur 1, weil in den aktiven Bereichen 12 und 14 besonders hohe Anforderungen an die Maßhaltigkeit der mit Hilfe des Musters 56 herzustellenden Schaltungsstruktur gestellt werden. Die Durchtrittsgebiete 100 bis 134 ragen zum großen Teil über die aktiven Bereiche 12 und 14 hinaus. Der genaue Verlauf der Durchtrittsgebiete 100 bis 134 wurde im Verfahrensschritt 54 ermittelt, siehe Figur 2.

Figur 4 zeigt das korrigierte Muster 64 für die korrigierte Phasensprungmaske. Auch die korrigierte Phasensprungmaske ist eine sogenannte Dunkelfeldmaske. Das korrigierte Muster 64 enthält Durchtrittsgebiete 140 bis 150, die in dieser Reihenfolge den Durchtrittsgebieten 100 bis 110 entsprechen. Jedoch sind die Durchtrittsgebiete 140 bis 150 aufgrund der im Verfahrensschritt 60 durchgeführten Korrektur in ihrem Umriss unregelmäßiger als die entsprechenden Durchtrittsgebiete 100 bis 110. Den Durchtrittsgebieten 140 bis 150 entsprechen in der korrigierten Phasensprungmaske Durchtrittsgebiete, die eine Phasenverschiebung von 0° erzeugen. Das Muster 64 enthält außerdem Durchtrittsgebiete 160 bis 174, die in dieser Reihenfolge den Durchtrittsgebieten 120 bis 134 entsprechen. Die Durchtrittsgebiete 160 bis 174 haben nicht so regelmäßige Umrisse wie die entsprechenden Durchtrittsgebiete 120 bis 134. Den Durchtrittsgebieten 160 bis 174 entsprechen in der korrigierten Phasensprungmaske Durchtrittsgebiete, die eine Phasenverschiebung von 180° verursachen. Auch die Durchtrittsgebiete 140 bis 150 wechseln sich mit den Durchtrittsgebieten 160 bis 174 ab, um zwischen benachbarten Durchtrittsgebieten einen Phasensprung von 180° zu erzeugen.

Zum Vergleich der Umrisse sind in Figur 4 drei Rahmen 180, 182 und 184 dargestellt, die den Umriss des dem Durchtrittsgebiet 160 entsprechenden Durchtrittsgebiets 120, den Umriss des im Durchtrittsgebiet 140 entsprechenden Durchtrittsgebiets 100 sowie den Umriss des dem Durchtrittsgebiet 162 entsprechenden Durchtrittsgebiets 122 zeigen. Es ist gut zu erkennen, dass die Durchtrittsgebiete 160, 140 und 162 länger sind als die entsprechenden Durchtrittsgebiete 120, 100 und 122. Durch die Verlängerung soll der bei der Belichtung auftretenden Linienverkürzung entgegengewirkt werden. Im Bereich der Ecken der Durchtrittsgebiete 160 bis 174 befinden sich meist sogenannte Serifen, die einer Eckenabrundung entgegenwirken sollen, siehe z. B. Serifen 190 und 192.

Figur 5 zeigt das unkorrigierte Muster 58 der Trimmmaske. Die Trimmmaske ist eine sogenannte Hellfeldmaske, bei der das Licht durch die in Figur 5 hell gezeichneten Flächen hindurchtritt. Das Muster 58 enthält zwei Abdeckbereiche 200 und 202. Ein dem Abdeckbereich 200 entsprechender Abdeckbereich der Trimmmaske würde bei der Belichtung die Bereiche überdecken, die durch Belichtung mit der unkorrigierten Phasensprungmaske im Bereich der Durchtrittsgebiete 100 bis 104 und 120 bis 126 belichtet werden würden. Der Abdeckbereich 200 ist bei der zum Muster 58 gehörenden Phasensprungmaske beispielsweise durch eine Chromschicht bedeckt, die den Durchtritt von Licht vollständig verhindert.

Dem Abdeckbereich 202 entspricht in der zum Muster 58 gehörenden Phasensprungmaske ein lichtundurchlässiger Bereich, der ein Gebiet überdeckt, das bei der Belichtung mit der Phasensprungmaske belichtet werden würde. Somit liegt der Abdeckbereich 202 im Muster 58 an den Positionen, an denen im Muster 56 die Durchtrittsbereiche 128 bis 134 liegen.

Das Muster 58 enthält außerdem außerhalb der Abdeckbereiche 200 und 202 Leitungsstrukturen 206 bis 214, die in dieser Reihenfolge den Leitungsstrukturen 16 bis 24 des Ursprungs-Layouts entsprechen, siehe auch Figur 1. Den Leitungsstrukturen 206 bis 214 würden in der unkorrigierten Trimmmaske Absorberstrukturen entsprechen, die das auftreffende Licht zu etwa 90 bis 95 % absorbieren. Die den Leitungsstrukturen 206 bis 214 entsprechenden Absorberstrukturen führen ebenfalls eine Verschiebung der Phase des auftreffenden Lichtes aus. Die Phasenverschiebung beträgt 180° im Vergleich zu dem durch die umliegenden Gebiete hindurchtretenden Licht.

Figur 6 zeigt das korrigierte Muster 72 der Trimmmaske, das im Verfahrensschritt 66 aus dem unkorrigierten Muster 58 erzeugt wird. Das korrigierte Muster 72 dient zur Herstellung einer korrigierten Trimmmaske, die ebenfalls eine Hellfeldmaske ist. Das Muster 72 enthält einen oberen Abdeckbereich 220, der aus dem Abdeckbereich 200 hervorgegangen ist. Ein unterer Abdeckbereich 222 ist aus dem Abdeckbereich 202 hervorgegangen. Zum Vergleich sind in Figur 6 die ursprünglichen Positionen der Abdeckbereiche 200 und 202 durch Rahmen 224 bzw. 226 verdeutlicht. Der Umriss der Abdeckbereiche 220 und 222 ist im Vergleich zum Umriss der Abdeckbereiche 200 und 202 unregelmäßiger. Es gibt in den Abdeckbereichen 220 und 222 sowohl Gebiete, die über die Rahmen 224 bzw. 226 hinausragen, als auch Gebiete, die innerhalb der Rahmen 224 bzw. 226 enden. Beide Korrekturmaßnahmen dienen jedoch dazu, Abbildungsfehler auszugleichen. Den Abdeckbereichen 220 und 222 entsprechende Abdeckbereiche der Trimmmaske werden mit einer Chromschicht überzogen und haben beispielsweise nur noch eine Transmission von $10^{-6}$.

Das Muster 72 enthält außerdem Leitungsstrukturen 236 bis 244, die in dieser Reihenfolge den Leitungsstrukturen 206 bis 214 des Musters 58 entsprechen. Der Verlauf der Leitungsstrukturen 236 bis 244 stimmt im wesentlichen mit dem Verlauf der Leitungsstrukturen 206 bis 214 überein. Jedoch sind die Ränder der Leitungsstrukturen 236 bis 244 aufgrund der im Verfahrensschritt 66, siehe Figur 2, ausgeführten Korrektur unregelmäßiger als die Ränder der Leitungsstrukturen 206 bis 214. Zum Vergleich ist in Figur 6 die ursprüngliche Lage der Ränder der Leitungsstrukturen 206 bis 214 durch Linien 250 dargestellt. Die Leitungsstrukturen 236 bis 244 ragen an einigen Stellen über die Linien 250 hinaus und liegen an anderen Stellen innerhalb der Linien 250.

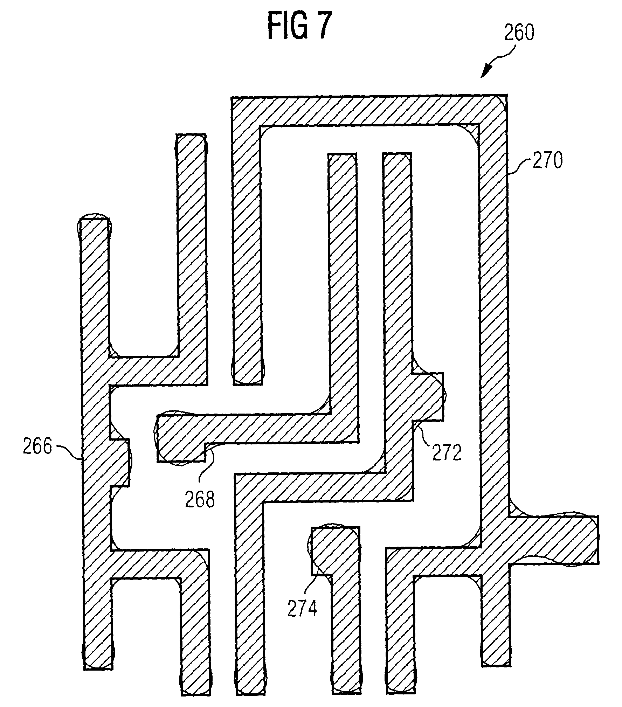

Figur 7 zeigt die Draufsicht auf einen integrierten Schaltkreis 260, dessen Herstellung mit Hilfe eines Simulationsprogramms unter Verwendung der korrigierten Muster 64 und 72 simuliert worden ist. Leitungsstrukturen 266 bis 274 zeigen die nach dem Entwickeln der Fotolackschicht noch mit Fotolack bedeckten Gebiete. Die Leitungsstrukturen 266 bis 274 entsprechen in ihrem Verlauf den Leitungsstrukturen 16 bis 24, vgl. Figur 1. Aufgrund der bei der Maskenherstellung auftretenden Effekte bzw. aufgrund der Simulation dieser Effekte sind die Umrisse der Leitungsstrukturen 266 bis 272 jedoch abgerundet und weichen von den in Figur 7 zum Vergleich eingezeichneten Umrissen der Leitungsstrukturen 16 bis 24 insbesondere an Ecken ab. Jedoch zeigt Figur 7, dass unter Verwendung der korrigierten Muster 64 und 72 ein Schaltkreis herstellbar ist, dessen Leitungsstrukturen nur unwesentlich vom Ursprungs-Layout 10 abweichen.

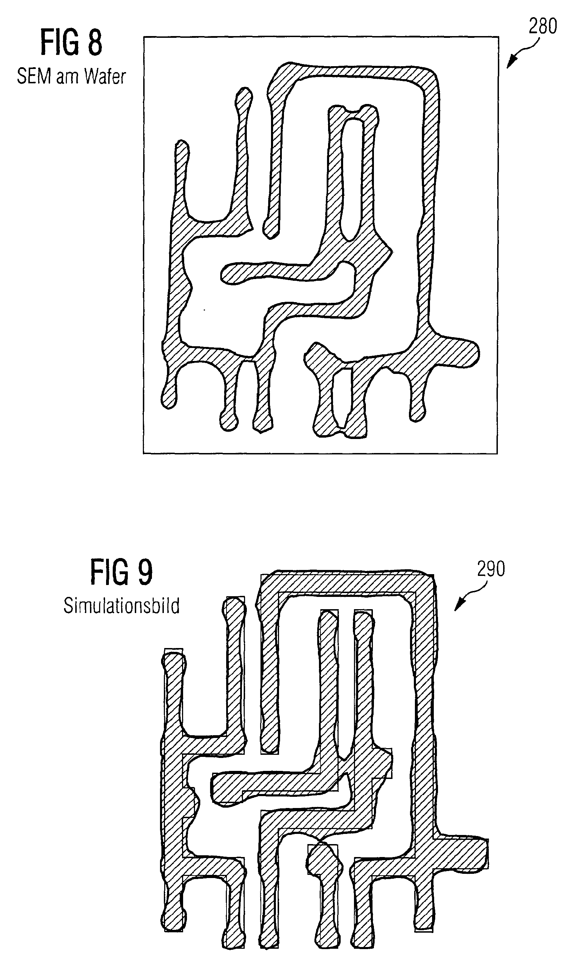

Figur 8 zeigt eine Aufnahme 280, die mit einem Raster-Elektronen-Mikroskop bei einem integrierten Schaltkreis aufgenommen worden ist, der unter Verwendung von Masken hergestellt worden ist, die aufgrund der unkorrigierten Muster 56 und 58 hergestellt worden sind. Den Leitungsstrukturen 16 bis 24 entsprechende Leitungsstrukturen des in Figur 8 gezeigten Schaltkreises sind durch weiße Umrisse umgeben. In Figur 8 sind deutlich Brücken zwischen den Leitungsstrukturen sowie erhebliche Abweichungen im Umriss ersichtlich.

Figur 9 zeigt das Ergebnis der Simulation des Herstellungsprozesses eines integrierten Schaltkreises 290. Bei der Simulation wurden ebenfalls die unkorrigierten Muster 56 und 58 verwendet. Die Simulation stimmt sehr gut mit der Aufnahme 280 überein. Demzufolge kann im Umkehrschluss davon ausgegangen werden, dass auch der unter Verwendung der korrigierten Muster 64 und 72 hergestellte Schaltkreis die durch den Schaltkreis 260 dargestellte Struktur hat.

Bei einem anderen Ausführungsbeispiel, das nicht anhand von Figuren erläutert wird, sind die außerhalb der aktiven Bereiche 12 und 14 liegenden Leitungsstrukturen breiter als die in Figur 1 dargestellten Leitungsstrukturen 16 bis 24. Außerdem haben die Leitungsstrukturen bei dem Ausführungsbeispiel außerhalb der Bereiche 12 und 14 einen größeren Abstand voneinander als die in Figur 1 gezeigten Leitungsstrukturen 16 bis 24. Aufgrund der größeren Breite und des größeren Abstandes ist die Herstellung der außerhalb der aktiven Bereiche 12 und 14 liegenden Leitungsstrukturen dann unkritischer als innerhalb der aktiven Bereiche 12 und 14. Aus diesem Grund lassen sich anstelle der zu den Leitungsstrukturen 206 bis 214 gehörenden Absorberstrukturen solche Absorberstrukturen einsetzen, die das gesamte auftreffende Licht absorbieren. Beispielsweise haben die Absorberstrukturen beim zweiten Ausführungsbeispiel eine Transmission von $10^{-6}$, weil sie durch eine Chromschicht gebildet werden.

Bei einem weiteren Ausführungsbeispiel wird im Verfahrensschritt 60 neben dem Muster 56 der Phasensprungmaske das unkorrigierte Muster 58 der Trimmmaske zur Nachbildung des Belichtungsprozesses eingesetzt, vgl. Figur 2, Pfeil 62.

Bezugszeichenliste

| | |
|---|---|
| 10 | Ursprungs-Layout |
| 12, 14 | aktiver Bereich |
| 16 bis 24 | Leitungsstruktur |
| 26 bis 34 | Anschlussfläche |
| 36 | Maßstabsstrecke |
| p | p-dotiert |
| n | n-dotiert |
| 50 | Start |
| 52 | Entwurf |
| 54 | Muster für Phasensprungmaske und Trimmmaske |
| 56 | unkorrigiertes Muster für Phasensprungmaske |
| 58 | unkorrigiertes Muster für Trimmmaske |
| 60 | Korrigieren des Musters der Phasensprungmaske |
| 62 | Pfeil |
| 64 | korrigiertes Muster für die Phasensprungmaske |
| 66 | Korrigieren des Musters der Trimmmaske |
| 68, 70 | Pfeil |
| 72 | korrigiertes Muster der Trimmmaske |
| 74 | Maskenherstellung (2 mal) + Lithografie |
| 100 bis 110 | Durchtrittsgebiet (0°) |
| 120 bis 134 | Durchtrittsgebiet (180°) |
| 140 bis 150 | Durchtrittsgebiet (0°) |
| 160 bis 174 | Durchtrittsgebiet (180°) |
| 180, 182, 184 | Rahmen |
| 190, 192 | Serife |
| 200, 202 | Abdeckbereich |
| 206 bis 214 | Leitungsstruktur |
| 220, 222 | Abdeckbereich |
| 224, 226 | Rahmen |
| 236 bis 244 | Leitungsstruktur |
| 250 | Linie |
| 260 | integrierte Schaltungsanordnung |
| 266 bis 272 | Leitungsstruktur |
| 280 | Aufnahme |
| 290 | integrierter Schaltkreis |

**Patentansprüche**

1. OPC-Verfahren zum Erzeugen von korrigierten Mustern (64, 72) für eine Phasensprungmaske und deren Trimmmaske,

   bei dem ein Ursprungs-Layout (10) zur Herstellung einer Schaltungsstruktur mit Hilfe eines Lithografieverfahrens (74) vorgegeben wird,

aus dem Ursprungs-Layout (10) ein Muster (56) für eine Phasensprungmaske erzeugt wird, die zur Herstellung eines Teils der Schaltungsstruktur dient,

bei dem aus dem Ursprungs-Layout (10) ein Muster (58) für eine Trimmmaske erzeugt wird, mit deren Hilfe sich an die Leitungsstrukturen des ersten Teils anschließende Strukturen der Schaltungsstruktur herstellbar sind,

und bei dem das Muster (56) für die Phasensprungmaske und das Muster (58) für die Trimmmaske unter Berücksichtigung von Nachbarschaften der Strukturen der Muster mit Einfluss auf die Abbildung bei der Photolithografie so korrigiert werden, dass eine mit korrigierten Mustern (64, 72) herstellbare Schaltungsstruktur hinsichtlich der Geometrie dem Ursprungs-Layout (10) ähnlicher als eine mit den unkorrigierten Mustern (56, 58) herstellbare Schaltungsstruktur ist,

**dadurch gekennzeichnet,**

**dass** bei der Korrektur zunächst in einem ersten Korrekturschritt (60) das Muster für die Phasensprungmaske nach Korrekturvorschriften für das Muster der Phasensprungmaske korrigiert wird,

und **dass** anschließend in einem zweiten Korrekturschritt (66) das Muster für die Trimmmaske bei Einsatz des korrigierten Musters (64) für die Phasensprungmaske nach Korrekturvorschriften für das Muster der Trimmmaske korrigiert wird,

oder dass bei der Korrektur zunächst in einem ersten Korrekturschritt das Muster für die Trimmmaske nach Korrekturvorschriften für das Muster der Trimmmaske korrigiert wird,

und **dass** anschließend in einem zweiten Korrekturschritt das Muster für die Phasensprungmaske bei Einsatz des korrigierten Musters für die Trimmmaske nach Korrekturvorschriften für das Muster der Phasensprungmaske korrigiert wird.

2. Verfahren nach Anspruch 1,
   **dadurch gekennzeichnet,**

   **dass** der erste Korrekturschritt (60) zur Korrektur des Musters der Phasensprungmaske bei Einsatz des unkorrigierten Musters (58) für die Trimmmaske ausgeführt wird,

oder **dass** der erste Korrekturschritt zur Korrektur des Musters der Trimmmaske bei Einsatz des unkorrigierten Musters (56) für die Phasenmaske ausgeführt wird,

3. Verfahren nach Anspruch 1 oder 2,
   **dadurch gekennzeichnet,**

   **dass** im ersten Korrekturschritt im wesentlichen alle bzw. alle Korrekturen des Musters für die zuerst korrigierte Maske nach den vorgegebenen Korrekturvorschriften für die die zuerst korrigierte Maske aufgeführt werden,

   und **dass** im zweiten Korrekturschritt im wesentlichen alle bzw. alle Korrekturen des Musters für die als zweite Maske korrigierte Maske nach den vorgegebenen Korrekturschriften für die als zweite Maske korrigierte Maske ausgeführt werden.

4. Verfahren nach einem der vorhergehenden Ansprüche,
   **dadurch gekennzeichnet,**

   **dass** die Muster (56, 58, 64, 72) durch Maskendaten festgelegt sind,
   und **dass** das Verfahren mit Hilfe mindestens einer Datenverarbeitungsanlage ausgeführt wird.

5. Verfahren nach einem der vorhergehenden Ansprüche,
   **dadurch gekennzeichnet,**
   **dass** die Korrektur automatisch ausgeführt wird.

6. Verfahren nach einem der vorhergehenden Ansprüche,
   **dadurch gekennzeichnet,**
   **dass** die korrigierten Muster (64, 72) als Grundlage bei der Simulation der Herstellung einer Phasensprungmaske und/oder einer Trimmmaske und/ oder eines integrierten Schaltkreises automatisch ausgeführt wird.

7. Vorrichtung zum Korrigieren von Mustern (64, 72) für eine Phasensprungmaske und deren Trimmmaske, insbesondere Datenverarbeitungsanlage,

   mit einer Speichereinheit zum Speichern der Daten eines Ursprungs-Layouts (10), der Daten eines Musters (56) für eine Phasensprungmaske und der Daten des Musters (58) für eine Trimmmaske,

   wobei das Ursprungs-Layout (10) zur Herstellung einer Schaltungsstruktur mit Hilfe eines Lithografieverfahrens dient,

die Phasensprungmaske zur Herstellung eines Teils der Schaltungsstruktur einsetzbar ist,

und wobei die Trimmmaske zum Herstellen der sich an die Schaltungsstrukturen des ersten Teils anschließenden Strukturen der Schaltungsstruktur einsetzbar ist,

und mit einer Korrektureinheit zur Korrektur des Musters (56) für die Phasensprungmaske und des Musters (58) für die Trimmmaske unter Berücksichtigung von Nachbarschaften der Strukturen der Muster mit Einfluss auf die Abbildung bei der Photolithografie derart, dass eine mit den korrigierten Mustern (64, 72) herstellbare Schaltungsstruktur hinsichtlich der Geometrie dem Ursprungs-Layout (10) ähnlicher als eine mit den unkorrigierten Mustern (56, 58) herstellbare Schaltungsstruktur ist,

wobei die Korrektureinheit so aufgebaut ist, dass bei der Korrektur zunächst in einem ersten Korrekturschritt (60) das Muster (56) für die Phasensprungmaske nach Korrekturvorschriften für das Muster der Phasensprungmaske korrigiert wird,

und **dass** anschließend in einem zweiten Korrekturschritt (66) das Muster für die Trimmmaske (58) bei Einsatz des korrigierten Musters (64) für die Phasensprungmaske nach Korrekturvorschriften für das Muster der Trimmmaske korrigiert wird,

oder wobei die Korrektureinheit so aufgebaut ist, dass bei der Korrektur zunächst in einem ersten Korrekturschritt das Muster für die Trimmmaske nach Korrekturvorschriften für das Muster der Trimmmaske korrigiert wird,

und **dass** anschließend in einem zweiten Korrekturschritt das Muster für die Phasensprungmaske bei Einsatz des korrigierten Musters für die Trimmmaske nach Korrekturvorschriften für das Muster der Phasensprungmaske korrigiert wird.

8.  Vorrichtung nach Anspruch 7,
    **dadurch gekennzeichnet,**
    **dass** sie so aufgebaut ist, dass bei ihrem Betrieb ein Verfahren nach einem der Ansprüche 1 bis 6 ausgeführt wird.

9.  Programm zum Erzeugen von korrigierten Mustern (64, 72) für eine Phasensprungmaske und deren Trimmmaske, mit einer Befehlsfolge, bei deren Ausführung durch einen Prozessor Daten eines Ursprungs-Layouts (10) zum Herstellen einer Schaltungsstruktur mit Hilfe eines Lithografieverfahrens, Daten eines Musters (56) für eine Phasensprungmaske und Daten eines Musters (58) für eine Trimmmaske gelesen werden,

wobei die Phasensprungmaske zur Herstellung eines Teils der Schaltungsstruktur einsetzbar ist,

und wobei die Trimmmaske zur Herstellung der sich an die Schaltungsstrukturen des ersten Teils anschließenden Strukturen der Schaltungsanordnung einsetzbar ist,

wobei das Muster (56) für die Phasensprungmaske und das Muster (58) für die Trimmmaske unter Berücksichtigung von Nachbarschaften der Strukturen der Muster mit Einfluss auf die Abbildung bei der Photolithografie so korrigiert werden, dass eine mit den korrigierten Mustern (64, 72) herstellbare Schaltungsstruktur hinsichtlich der Geometrie dem Ursprungs-Layout (10) ähnlicher als einer mit den unkorrigierten Mustern (56, 58) herstellbare Schaltungsstruktur ist,

wobei zunächst in einem ersten Korrekturschritt (60) das Muster (56) für die Phasensprungmaske nach Korrekturvorschriften für das Muster der Phasensprungmaske korrigiert wird,

und wobei anschließend in einem zweiten Korrekturschritt (66) das Muster für die Trimmmaske bei Einsatz des korrigierten Musters (64) für die Phasensprungmaske nach Korrekturvorschriften für das Muster der Trimmmaske korrigiert wird.

oder wobei zunächst in einem ersten Korrekturschritt das Muster für die Trimmmaske nach Korrekturvorschriften für das Muster der Trimmmaske korrigiert wird,

und wobei anschließend in einem zweiten Korrekturschritt das Muster für die Phasensprungmaske bei Einsatz des korrigierten Musters für die Trimmmaske nach Korrekturvorschriften für das Muster der Phasensprungmaske korrigiert wird.

10. Programm nach Anspruch 9,
    **dadurch gekennzeichnet,**
    **dass** ein Teil der Befehle in einer Datei enthalten ist, die Befehle einer Kommandosprache zur Steuerung des Programms enthält.

11. Programm nach Anspruch 9 oder 10,
**dadurch gekennzeichnet,**
**dass** bei der Ausführung der Befehle ein Verfahren nach einem der Ansprüche 1 bis 6 ausgeführt wird.

12. Integrierte Schaltungsstruktur (260),
**dadurch gekennzeichnet,**
**dass** die Schaltungsstruktur (260) unter Verwendung einer Phasensprungmaske und einer Trimmmaske hergestellt worden ist, denen ein mit Hilfe eines Verfahrens gemäß einem der Ansprüche 1 bis 6 erzeugtes Muster zugrundeliegt.

13. Phasensprungmaske,
**dadurch gekennzeichnet,**
**dass** ihr Muster mit Hilfe eines Verfahrens gemäß einem der Ansprüche 1 bis 5 erzeugt worden ist.

14. Trimmmaske,
**dadurch gekennzeichnet,**
**dass** ihr Muster mit Hilfe eines Verfahrens gemäß einem der Ansprüche 1 bis 6 erzeugt worden ist.

# FIG 1

## FIG 2

Start — 50

↓

Entwurf — 52

↓

FIG. 1 | Ursprungs-Layout | — 10

↓

Muster für Phasenmaske und Trimmmaske — 54

56 — alternierende Phasenmaske (Dunkelfeld) — FIG. 3

58 — Trimmmaske (Hellfeld) ggf. 3-Ton — FIG. 5

62

60 — korrigieren der Phasenmaske

70

64 — korrigierte Phasenmaske — FIG. 4

68

66 — korrigieren der Trimmmaske

74 — Maskenherstellung (2x) + Lithografie

72 — korrigierte Trimmmaske — FIG. 6

# FIG 3

für Dunkelfeldmaske

120  100  122  102  124  104  126  56

128  106  130  108  132  110  134

0°  180°

# FIG 4

für Dunkelfeldmaske

182  184  64

180

160  190  140  162  142  164  144  166

168  192  146  170  148  172  150  174

0°  180°

# FIG 5
für Hellfeldmaske

# FIG 6
für Hellfeldmaske

FIG 7

FIG 8
SEM am Wafer

280

FIG 9
Simulationsbild

290